# EUROPEAN PATENT APPLICATION

(11) **EP 3 499 593 A1**
(43) Date of publication of application: **19.06.2019**
(21) Application number: 17207552.5
(22) Date of filing: 15.12.2017
(51) Int. Cl.: H01L 41/09, H02N 2/00

(54) **ELECTROMECHANICAL ACTUATOR**

(71) Applicant: Physik Instrumente (PI) GmbH & Co. KG, 76228 Karlsruhe (DE)
(72) Inventor: Koc, Burhanettin, 76275 Ettlingen (DE); Delibas, Bülent, 76356 Weingarten (DE)

(57) **Abstract**

The inventions describes an electromechanical actuator for an ultrasonic motor in the shape of an n-sided regular polygon plate with n being equal to or greater than five, said polygon plate having two larger main surfaces and at least five smaller side surfaces connecting the main surfaces with each other, and with two electrodes arranged on one of the main surfaces and with at least one electrode arranged on the other of the main surfaces, the polygon plate comprising an electromechanical material that undergoes a deformation when an electric voltage is applied to the electrodes arranged at the main surfaces, and with the two electrodes arranged on one of the main surfaces being electrically isolated from each other by a linear isolation area, wherein the material of the electromechanical actuator comprises a single or polycrystalline piezoelectric ceramic with its piezoelectric charge constant d₃₁ differing from its piezoelectric charge constant d₃₂ both in sign and in value, with the piezoelectric charge constant d₃₁ defining a first main deformation direction of the actuator and with the piezoelectric charge constant d₃₂ defining a second main deformation direction of the actuator, and with the first main deformation and the second main deformation direction being arranged perpendicular to each other, wherein the orientation of the linear isolation area is parallel to the first main deformation direction or to the second main deformation direction.

## Description

The invention is related to an electromechanical actuator according to claim 1, and to a corresponding excitation method according to claim 4.

Piezoelectric materials have the feature of converting electrical energy into mechanical energy and vice versa and thus have electromechanical properties. These materials are used in various sensor and actuator devices in many different technical fields. One of the well-established piezoelectric ceramic is lead zirconate titanate (abbreviated: PZT) based material, which has anisotropic properties and belongs to the hexagonal crystal symmetry class of 6mm. Due to said crystal symmetry, PZT based ceramic materials have equal piezoelectric charge constants d₃₁ and d₃₂ in transverse directions. The subscript numbers 31 and 32 are defined as induced strain in direction 1 per unit applied electrical voltage in direction 3, or induced strain in direction 2 per unit applied electrical voltage in direction 3, respectively. Because the piezoelectric charge constants d₃₁ and d₃₂ for PZT based ceramic material in two orthogonal transverse directions are equal, only one parameter, for example d₃₁, is enough to represent piezoelectric charge constants of this material in transverse directions.

The signs of the piezoelectric charge constants d₃₁ and d₃₂ of PZT based ceramic materials are negative compared to the longitudinal or thickness mode piezoelectric charge constant d₃₃. Because of this property, a radial or a planar mode on a corresponding plate-shaped element is possible to be excited even if the excitation electrodes are not completely covering the main surfaces of the plate-shaped element.

Single crystal piezoelectric materials with orthorhombic mm2 symmetry class not only have larger electromechanically coupling with much larger (up to 10 times) piezoelectric charge constants; their piezoelectric charge constant in two transverse directions is also different both in sign and value. While the value of d₃₁ is negative and relatively small, the value of d₃₂ is positive and relatively large. As a result, unusual modes can be excited with single crystal piezoelectric materials which are not common for PZT based materials.

In the scientific article 'A face-shear mode single crystal ultrasonic motor' by Li et al., Applied Physics Letters 102, 183512 (2013), the authors describe an ultrasonic motor using phase-shear mode coupling of a quadratic plate made of PIN-PMN-PT with a symmetry of mm2 after poling. On one of the large or main plane surfaces of the quadratic plate, two excitation electrodes are arranged such that a line-shaped gap, which electrically isolates both excitation electrodes from each other, is oriented in the diagonal direction of the quadratic plate. The other of the large or main plane surfaces is fully covered with a single common electrode.

One corner of the quadratic plate, where the diagonally oriented line-shaped gap arranged between the two excitation electrodes is ending, is used as the contact point intended for an intermittent friction contact with an element to be driven. When one half of the quadratic plate is excited electrically by applying a sinusoidal signal between one of the excitation electrodes and the common electrode (while keeping the other excitation electrode floating), a phase-shear mode is excited due to the characteristics of the piezoelectric shear mode coupling coefficient d36 of single crystal material, and said phase-shear mode is used to drive the element to be driven in the desired motion direction.

In order to change the motion direction, the corresponding other excitation electrode needs to be electrically excited in an analogue matter. Although both excitation electrodes are identically shaped and even if the same electrical voltage or signal is applied, the generated motion of the element to be driven in the different directions is not identical due to the alignment of the excitation electrodes to the crystal orientation of the piezoelectric material of the quadratic plate. As a consequence, the performance of such kind of ultrasonic motor with respect to the generated speed and push pull force is direction dependent, which is the main drawback of this structure.

It is therefore the aim of this invention to provide an electromechanical element for an ultrasonic motor comprising a single crystalline piezoelectric ceramic where the performance as regards the generated speed of an element to be driven and regarding the push or pull force transferable to the element to be driven is independent from the driving direction. It is also the aim of this invention to provide an excitation method for the inventive electromechanical element in order to realize an ultrasonic motor with higher performance.

The aforementioned aim is solved by electromechanical element according to claim 1 and with an excitation method according to claim 4, with the respective subclaims describing at least beneficial improvements.

The inventive electromechanical actuator for an ultrasonic motor has the shape of an n-sided regular polygon plate with n being equal to or greater than five. The polygon plate has two larger main surfaces, with the main surfaces being plane surfaces preferably. The two main surfaces are connected to each other via at least five smaller side surfaces. Two electrodes are arranged on one of the main surfaces, and at least one electrode is arranged on the other of the main surfaces. The two electrodes arranged on one of the main surfaces are electrically isolated from each other by a linear or line-shaped isolation area.

The polygon plate comprises an electromechanical material that undergoes a deformation when an electric voltage is applied to the electrodes arranged at the main surfaces, wherein the material of the electromechanical actuator comprises a single crystalline piezoelectric ceramic with its piezoelectric charge constant d₃₁ differing from its piezoelectric charge constant d₃₂ both in sign as well as in value, with the piezoelectric charge constant d₃₁ defining a first main deformation direction of the actuator and with the piezoelectric charge constant d₃₂ defining a second main deformation direction of the actuator, and with the first main deformation and the second main deformation direction being arranged perpendicular to each other, wherein the orientation of the linear isolation area is parallel to the first main deformation direction or to the second main deformation direction.

It is preferable that on at least one of the side surfaces at least one friction means, most preferable a friction element, intended for a friction contact with an element to be driven or moved is arranged. However, it is not necessarily required that there is arranged a friction means on the side surface of the polygon plate of the electromechanical element being intended for friction contact with an element to be driven.

It is also preferable that the two electrodes arranged on one of the main surfaces are excitation electrodes of different size or surface coverage, respectively, and with two electrodes arranged on the other of the main surfaces being excitation electrodes of different size or surface coverage, respectively, where the larger of the electrodes on the different main surfaces are arranged such that they overlap partially at the most. In other words, the larger of the electrodes arranged on the different main surfaces are not placed in registration or in identical coverage, respectively.

According to an excitation method of the afore described inventive electromechanical actuator, the two electrodes arranged on one of the main surfaces are excitation electrodes and that the one electrode arranged on the other main surface is a common electrode, where a first excitation voltage U1 is applied to one of the two excitation electrodes, and with the other of the two excitation electrodes kept floating, and with the common electrode being applied with a second excitation voltage U2 having a phase difference of 180° with respect to the first excitation voltage U1.

It is preferable that a first excitation voltage U1 is applied to the larger excitation electrode arranged on one of the main surfaces and that the larger excitation electrode arranged on the other main surface is kept floating, and with each of the smaller excitation electrodes being grounded.

It is also preferable that a first voltage U1 is applied to the larger excitation electrode arranged on one of the main surfaces and that the larger excitation electrode arranged on the other main surface is kept floating, and where a second excitation voltage U2 having a phase difference of 180° with respect to the first excitation voltage U1 is applied to each of the smaller excitation electrodes.

In addition, it is preferable that a resonance vibration mode, preferably the first resonance vibration mode, of the excited or driven part of the electromechanical actuator is excited by application of the voltage U1 or by the combined application of the voltages U1 and U2 such that a perturbed first longitudinal mode is excited in the whole electromechanical actuator which results in in an oblique motion of the friction means.

In the following, the invention is described by means of figures showing different embodiments of the invention.
Fig. 1: one embodiment of the inventive electromechanical actuator together with a suitable electrical connection
Fig. 2: FEM mesh showing the simulation results for both states of maximum deformation of the electrically excited electromechanical actuator according to Fig. 1
Fig. 3: electromechanical actuator according to Fig. 1 with a different electrical connection for a reverse driving direction
Fig. 4: FEM mesh showing the simulation results for both states of maximum deformation of the electrically excited electromechanical actuator according to Fig. 3
Fig. 5 (a) - (c): three further embodiments of the inventive electromechanical actuator
Fig. 6: Block diagram showing a driving principle for an inventive electromechanical actuator
Fig. 7: Block diagram showing another driving principle for an inventive electromechanical actuator

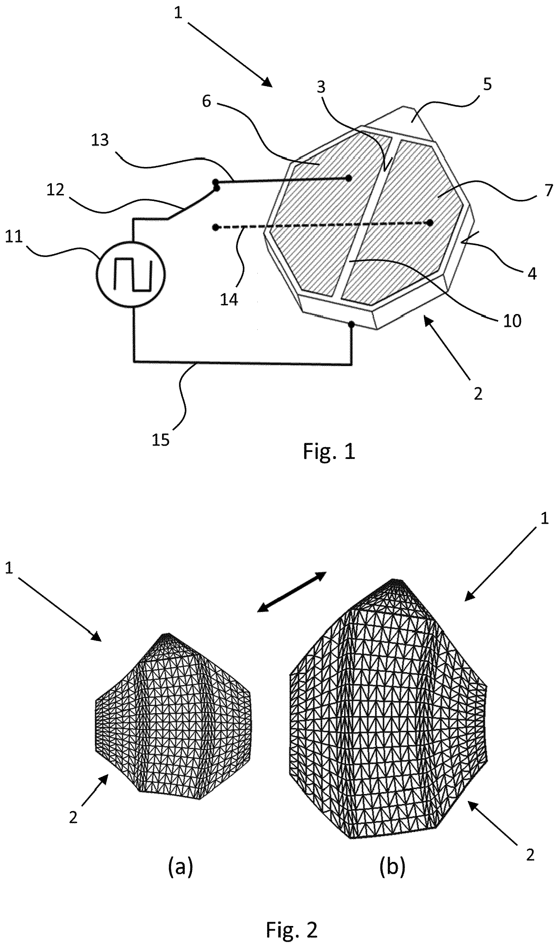

Fig. 1 shows a perspective view of an inventive electromechanical actuator 1 in form of an eight-sided regular polygon plate 2 made from a single crystalline piezoelectric ceramic, where only one of the two planar main surfaces 3 of the polygon plate 2 is visible. The other of the both main surfaces 3 is on the rear side of the polygon plate 2 and thus not visible in Fig. 1.

The two main surfaces 3 are connected to each other via eight side surfaces 4, where a friction means 5 in form of a friction element is attached to one of the side surfaces 4.

On the visible main surface 3, two equally shaped and sized excitation electrodes 6 and 7 realized by a corresponding metallization layer or portion are arranged such that they are electrically isolated from each other by a linear isolation area 10. The excitation electrodes 6 and 7 are symmetrically arranged about said linear or shaped-line isolation area 10.

The non-visible main surface has only one electrode being a common electrode which has been also realized by a metallization layer deposited or attached to said main surface. The one-piece common electrode covers nearly the whole area of the main surface except of a small peripheral zone near to the edges of the polygon plate 2.

The friction element 5 has a triangular shape with its base attached to one of those side surfaces 4 where the linear isolation area 10 ends. Here, the linear isolation area is arranged substantially orthogonal to the side surface 4 the friction element 5 is attached to and to the parallel and oppositely arranged side surface. The free and slanted surfaces of the triangular shaped friction element 5 are parallely arranged to the respective adjacent side surfaces of the polygon plate 2.

The piezoelectric charge constant d₃₁ of the single crystalline piezoelectric ceramic of the polygon plate differs from the piezoelectric charge constant d₃₂ both in sign and in value. The piezoelectric charge constant d₃₁ defines a first main deformation direction of the electromechanical actuator 1, and the piezoelectric charge constant d₃₂ is defining a second main deformation direction of the electromechanical actuator 1, with the first main deformation and the second main deformation direction being arranged perpendicular to each other. The orientation of the linear isolation area 10 is parallel to the first main deformation direction or to the second main deformation direction.

An AC voltage source 11 is connected by a lead wire 13 with the excitation electrode 6, where the switch 12 is correspondingly closed in order to realize an electrical connection between the AC voltage source 11 and the lead wire 13 or the excitation electrode 6, respectively. The other pole of the AC voltage source 11 is connected via a lead wire 15 with the non-visible common electrode arranged on the non-visible main surface 3.

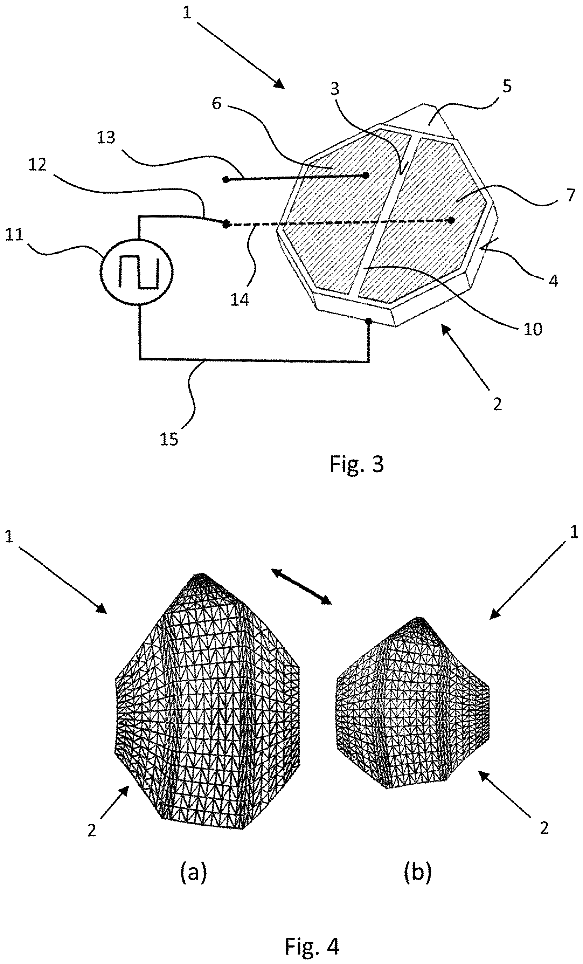

The dashed line in Fig. 1 shows a further (non-used) lead wire 14 that is intended for connecting the other excitation electrode 7 via the switch 12 with the AC voltage source 11 in order to generate a reverse motion of the electromechanical actuator (see Figs. 3 and 4).

Fig. 2 illustrates the maximum deformations of the polygon plate 2 of the inventive electromechanical actuator 1 when an AC voltage is applied to it according to Fig. 1. Fig. 2 (a) shows the mesh model of a FEM calculation for one of the maximum deformations of the polygonal plate 2 of the electromechanical actuator 1 where the friction element is in the most rearward position in relation to the its intended drive motion (characterized by the double arrow in Fig. 2). In contrast thereto, Fig. 2 (b) shows the mesh model of a FEM calculation for the other of the maximum deformations of the polygonal plate 2 of the electromechanical actuator 1 where the friction element is in the most forward position related to its intended drive motion. In other words, the deformations created within the polygonal plate of the electromechanical actuator due to the corresponding electrical excitation according to Fig. 1 are suited for driving an element to be driven (by friction contact with the friction element) in the right direction in Fig. 2.

Fig. 3 shows the electromechanical actuator 1 according to Fig. 1 with the same driving principle, and the only difference compared to Fig. 1 is the connection of the excitation electrode 7 (instead of excitation electrode 6) with the AC voltage source 11 due to the correspondingly closed switch 12. The application of a suitable AC voltage signal to the other of the excitation electrodes results in a reverse deformation of the polygon plate 2 of the electromechanical element 1 which is suitable for a motion of the element to be driven by the electromechanical actuator in a reverse direction compared to that according to Figs. 1 and 2.

The corresponding results of a FEM simulation of the maximum deformations of the polygon plate of the electromechanical actuator are shown in Figs. 4 (a) and 4 (b), which correspond to a mirroring of the results shown in Figs. 2 (a) and 2 (b). In other words, the maximum deformations achievable with the inventive electromechanical actuator are substantially the same for the reverse driving directions.

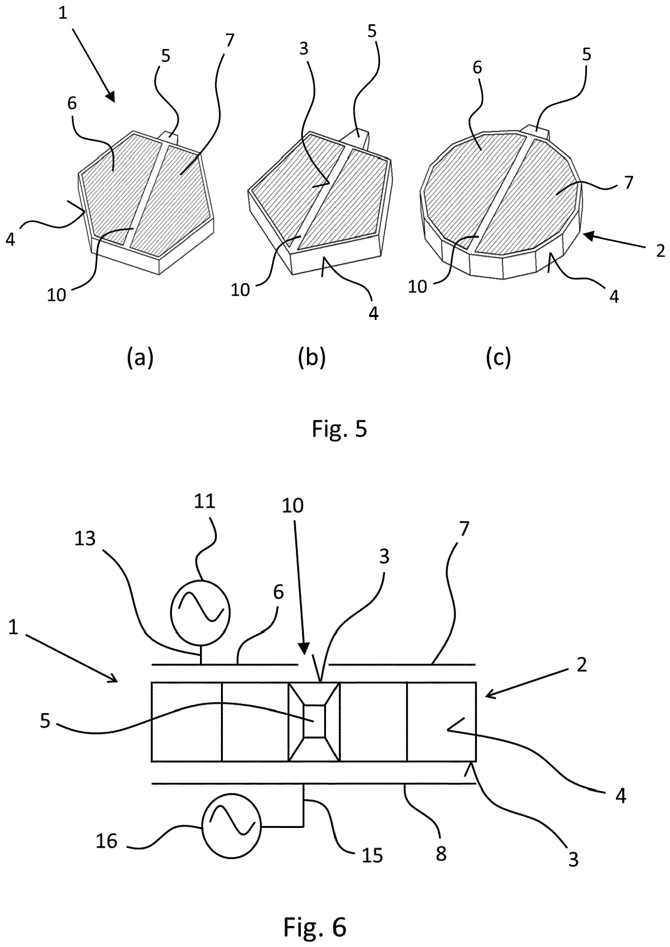

Fig. 5 shows three further possible embodiments for an inventive electromechanical actuator 1. Fig. 5 (a) shows an electromechanical actuator 1 with a six-sided regular polygon plate 2 having two equally shaped and sized excitation electrodes on one (the visible) main surface 3, being electrically isolated from each other by a linear or line-shaped isolation area 10, and with the excitation electrodes 6 and 7 being symmetrically arranged about said linear or shaped-line isolation area 10. One single-piece common electrode (not visible) is arranged at the non-visible other main surface. One friction element 5 is attached to one of those side surfaces 4 of the six-sided polygon plate where the linear isolation area 10 ends, with the linear isolation area 10 being arranged perpendicular to said side surface.

Fig. 5 (b) shows an electromechanical actuator 1 with a five-sided regular polygon plate 2 having two equally shaped and sized excitation electrodes on one (the visible) main surface 3, being electrically isolated from each other by a linear or line-shaped isolation area 10, and with the excitation electrodes 6 and 7 being symmetrically arranged about said linear or shaped-line isolation area 10. One single-piece common electrode (not visible) is arranged at the non-visible other main surface. One friction element 5 is attached to that side surface 4 of the five-sided polygon plate where the linear isolation area 10 ends, with the linear isolation area 10 being arranged perpendicular to said side surface.

Fig. 5 (c) shows an electromechanical actuator 1 with a fifteen-sided regular polygon plate 2 having two equally shaped and sized excitation electrodes on one (the visible) main surface 3, being electrically isolated from each other by a linear or line-shaped isolation area 10, and with the excitation electrodes 6 and 7 being symmetrically arranged about said linear or shaped-line isolation area 10. One single-piece common electrode (not visible) is arranged at the non-visible other main surface. One friction element 5 is attached to one of those side surfaces 4 of the fifteen-sided polygon plate where the linear isolation area 10 ends, with the linear isolation area 10 being arranged perpendicular to said side surface.

Fig. 6 shows a block diagram for a possible electrical connection or a driving principle, respectively, of an inventive electromechanical actuator. The electromechanical actuator 1 has two excitation electrodes 6 and 7 on one of its main surfaces 3 with said excitation electrodes 6 and 7 being separated or electrically isolated from each other by a linear isolation area 10. The excitation electrode 6 is connected via lead wire 13 with a first AC voltage source 11 supplying a first excitation voltage U1, whereas the excitation electrode 7 is kept floating.

A single common electrode 8 is arranged on the other of the two main surfaces 3. The common electrode 8 is connected via lead wire 15 with a second AC voltage source 16 supplying a second excitation voltage U2. The second excitation voltage U2 has a phase difference of 180° with respect to the first excitation voltage U1.

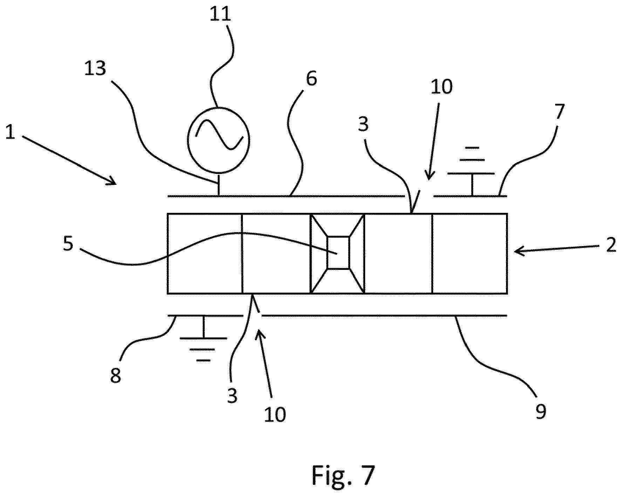

Fig. 7 shows a block diagram for a further possible electrical connection or driving principle, respectively, of an inventive electromechanical actuator. The electromechanical actuator 1 has two excitation electrodes 6 and 7 of different size or surface coverage on one of its main surfaces 3, where the surface coverage of excitation electrode 6 is larger than that of excitation electrode 7. Again, the excitation electrodes 6 and 7 are separated or electrically isolated from each other by a linear isolation area 10. The excitation electrode 6 is electrically connected to an AC voltage source 11 by lead wire 13, whereas excitation electrode 7 is connected to ground or is grounded, respectively.

Two excitation electrodes 8 and 9 of different size or surface coverage are arranged on the other main surface 3, where said excitation electrodes 8 and 9 are separated or electrically isolated from each other by a linear isolation area 10. Here, excitation electrode 9 covers a larger area than excitation electrode 8, with the excitation electrodes 6 and 9 having approximately the same larger size, and with excitation electrodes 7 and 8 having approximately the same smaller size. The larger of the excitation electrodes on both main surfaces 3, namely the excitation electrodes 6 and 9, are arranged such that they overlap with each other partially at the most, and the linear isolation area 10 between the excitation electrodes 6 and 7 is not in registration and thus not overlapping with the linear isolation area 10 between the excitation electrodes 8 and 9. The excitation electrode 9 is kept floating, while the excitation electrode 8 is grounded.

The working or driving principle of the inventive electromechanical actuator is as follows: when one half of the single crystalline piezoelectric ceramic of the polygon plate of the inventive electromechanical actuator is electrically excited, the sign difference between the piezoelectric charge constants d₃₁ and d₃₂ makes the excited section of the polygon plate to move at a larger magnitude of displacement compared to the non-excited half of the polygon plate. As a result, the excited section or excited half, respectively, makes a motion that is similar to a motion corresponding to a combined excitation of the first bending and the first longitudinal mode. However, the generated mode is not a coupled one of two orthogonal vibration modes, but it is a unique non-symmetric single longitudinal mode.

With the inventive electromechanical actuator, a simplified bulk structure can be realized, and the driving voltage of a corresponding ultrasonic motor - even with the bulk structure of the piezoelectric ceramic - can be reduced to a range between 10 and 20 Volt, which is a prerequisite for some industries like medical applications. 'Bulk structure' in the aforementioned means the absence of a multilayer structure where electrodes are not only arranged at the surfaces of the electromechanical actuator, but with an additional multitude of electrode layers inside the piezoelectric ceramic.

Furthermore, the performance of an ultrasonic motor with the inventive electromechanical actuator can be improved compared to an ultrasonic motor having a poly-crystalline PZT-based actuator due to the higher maximum power density and their higher figure of merits of single crystalline piezoelectric ceramics.

A further advantage of the inventive electromechanical actuator is that the vibration modes of single crystal materials have lower operating frequencies than the vibration modes of PZT materials. Thus, miniaturized ultrasonic motors can be operated with moderate operating frequencies (i.e. < 500 kHz).

Finally, with the inventive electromechanical actuator no geometric aspect ratios have to be met in order to generate useful modes. Thus, there is no need for tight manufacturing tolerances as regards the geometry of the polygon plate.

## Claims

1. An electromechanical actuator (1) for an ultrasonic motor in the shape of an n-sided regular polygon plate (2) with n being equal to or greater than five, said polygon plate (2) having two larger main surfaces (3) and at least five smaller side surfaces (4) connecting the main surfaces (3) with each other, and with two electrodes (6, 7) arranged on one of the main surfaces (3) and with at least one electrode (8) arranged on the other of the main surfaces, the polygon plate (2) comprising an electromechanical material that undergoes a deformation when an electric voltage is applied to the electrodes (6, 7, 8) arranged at the main surfaces, and with the two electrodes (6, 7) arranged on one of the main surfaces being electrically isolated from each other by a linear isolation area (10), wherein the material of the electromechanical actuator comprises a single crystalline piezoelectric ceramic with its piezoelectric charge constant d₃₁ differing from its piezoelectric charge constant d₃₂ both in sign and in value, with the piezoelectric charge constant d₃₁ defining a first main deformation direction of the actuator (1) and with the piezoelectric charge constant d₃₂ defining a second main deformation direction of the actuator (1), and with the first main deformation and the second main deformation direction being arranged perpendicular to each other, wherein the orientation of the linear isolation area (10) is parallel to the first main deformation direction or to the second main deformation direction.

2. Electromechanical actuator according to claim 1, **characterized in that** on at least one of the side surfaces (4) at least one friction means is arranged.

3. Electromechanical actuator according to claim 1 or 2, **characterized in that** the two electrodes (6, 7) arranged on one of the main surfaces (3) are excitation electrodes of different surface coverages with one excitation electrode being larger than the other excitation electrode, and with two electrodes (8, 9) arranged on the other of the main surfaces (3) being excitation electrodes of different surface coverages with one excitation electrode being larger than the other excitation electrode, where the larger electrode arranged on one of the main surfaces is overlapping partially at the most with the larger electrode arranged on the respective other of the main surfaces.

4. Method for electrical excitation of the electromechanical actuator according to claim 1 or 2, **characterized in that** the two electrodes (6, 7) arranged on one of the main surfaces (3) being excitation electrodes and that the one electrode (8) arranged on the other main surface (3) being a common electrode, where a first excitation voltage U1 is applied to one of the two excitation electrodes, and with the other of the two excitation electrodes kept floating, and with the common electrode (8) being applied with a second excitation voltage U2 having a phase difference of 180° with respect to the first excitation voltage U1.

5. Method for electrical excitation of the electromechanical actuator according to claim 3, **characterized in that** a first voltage U1 is applied to the larger excitation electrode arranged on one of the main surfaces (3) and that the larger excitation electrode arranged on the other main surface (3) is kept floating, and with each of the smaller excitation electrodes being grounded.

6. Method for electrical excitation of the electromechanical actuator according to claim 3, **characterized in that** a first voltage U1 is applied to the larger excitation electrode arranged on one of the main surfaces (3) and that the larger excitation electrode arranged on the other main surface (3) is kept floating, and where a second excitation voltage U2 having a phase difference of 180° with respect to the first excitation voltage U1 is applied to each of the smaller excitation electrodes.

7. Method according to one of the claims 4 to 6, **characterized in that** a resonance vibration mode of the excited part of the electromechanical actuator (1) is excited by application of the voltage U1 or by the combined application of the voltages U1 and U2 such that a perturbed first longitudinal mode is excited in the electromechanical actuator which results in in an oblique motion of the friction means.

8. Ultrasonic motor with an electromechanical actuator according to claims 1 to 3.
